# EUROPEAN PATENT APPLICATION

(11) **EP 3 964 605 A1**
(43) Date of publication of application: **09.03.2022**
(21) Application number: 20194371.9
(22) Date of filing: 03.09.2020
(51) Int. Cl.: C23C 14/28

(54) **DEVICE FOR PULSED LASER DEPOSITION**

(71) Applicant: Solmates B.V., 7521 PE Enschede (NL)
(72) Inventor: Heuver, Jeroen Aaldert, 7522 DA Enschede (NL); Hopman, Willem Cornelis Lambert, 7525 EH Deventer (NL); Bohm, Kristiaan Hendrikus Aloysius, 7412 AD Deventer (NL); Dekkers, Jan Matthijn, 7611 CB Aadorp (NL); Janssens, Jan Arnaud, 7433 BJ Schalkhaar (NL)
(74) Representative: 't Jong, Bastiaan Jacob

(57) **Abstract**

The invention relates to a device for pulsed laser deposition, a substrate with a substrate surface and a target with a target surface, which device comprises:
- a reactor housing having a pump inlet and a pump outlet for providing a desired gas atmosphere in the reactor housing;
- a substrate holder arranged in the reactor housing for holding the substrate;
- a target holder arranged in the reactor housing for holding the target with the target surface facing the substrate surface of the substrate;
- a velocity filter arranged in the reactor housing and between the substrate holder and the target holder, which velocity filter comprises a rotating, generally disc-shaped body with a rotation axis and with at least one filter passage opening extending from one axial surface facing the target holder to the other axial surface of the rotating body facing the substrate holder;
- a pulsed laser directed through a window arranged in the reactor housing onto the target at a target spot for generating a plasma plume of target material, wherein the surface of the target at the target spot faces the substrate surface, wherein the path of the at least one filter passage opening coincides with the target spot when viewed in a direction perpendicular to the surface of the target at the target spot; and
- a partition wall arranged in the reactor housing, which partition wall extends between the substrate holder and the target holder, wherein the rotating, generally disc-shaped body of the velocity filter is arranged in an opening in the partition wall, wherein the circumference of the rotating body is enclosed by the edge of the opening in the partition wall and and wherein the distance between the edge of the opening and the circumference of the rotating body in radial direction is between 10mm and 30mm.

## Description

The invention relates to a device for pulsed laser deposition, a substrate with a substrate surface and a target with a target surface, which device comprises:
- a reactor housing having a pump inlet and a pump outlet for providing a desired gas atmosphere in the reactor housing;
- a substrate holder arranged in the reactor housing for holding the substrate;
- a target holder arranged in the reactor housing for holding the target with the target surface facing the substrate surface of the substrate;
- a velocity filter arranged in the reactor housing and between the substrate holder and the target holder, which velocity filter comprises a rotating, generally disc-shaped body with a rotation axis and with at least one filter passage opening extending from one axial surface facing the target holder to the other axial surface of the rotating body facing the substrate holder; and
- a pulsed laser directed through a window arranged in the reactor housing onto the target at a target spot for generating a plasma plume of target material, wherein the surface of the target at the target spot faces the substrate surface,
wherein the path of the at least one filter passage opening coincides with the target spot when viewed in a direction perpendicular to the surface of the target at the target spot.

Such a device is for example known from EP 2410074 or EP 3587620.

In these devices a substrate is provided by a layer of target material. The pulsed laser is directed on the target and a plasma plume of target material is ejected towards the substrate to form a layer of target material on the substrate surface. When the plasma plume is generated also undesired particles come loose from the target material. As these undesired particles have a lower speed and are trailing the plasma plume, it is known to filter these undesired particles with a velocity filter.

Such a velocity filter is a rotating, generally disc-shaped body with at least one filter passage opening. By controlling the speed of the rotating body and synchronizing it with the pulsed laser, it is possible to let the plasma plume pass the velocity filter via the filter passage opening, while the slower, undesired particles are blocked by the rotating body, as the filter passage opening has already moved on. These blocked, undesired particles will partially adhere to the surface of the rotating body, but some will keep floating in the space between the target and the rotating body. These floating particles could be dragged along with a next generated plasma plume and as a result still end up in the deposited layer on the surface of the substrate.

It is an object of the invention to reduce or even remove the above mentioned disadvantages.

This object is achieved according to the invention with a device according to the preamble, which is characterized by a partition wall arranged in the reactor housing, which partition wall extends between the substrate holder and the target holder, wherein the rotating, generally disc-shaped body of the velocity filter is arranged in an opening in the partition wall, wherein the circumference of the rotating body is enclosed by the edge of the opening in the partition wall and wherein the distance between the edge of the opening and the circumference of the rotating body in radial direction is between 10mm and 30mm.

The reactor housing is divided by the partition wall into two portions, a substrate side portion and a target side portion. The pump inlet and pump outlet of the reactor housing are used to obtain a desired gas atmosphere in the reactor housing. As a result a gas flow is present between the pump inlet and pump outlet. Because the circumference of the rotating body is enclosed by the edge of the opening in the partition wall and a distance between the edge of the opening and the circumference of the rotating body in radial direction of between 10mm and 30mm is present, a gas flow over the rotating body along the full circumference thereof towards the pump outlet is obtained. As a result the gas flow will drag floating undesired particles along and into the pump outlet, such that these particles can no longer contaminate the substrate.

Typically, the pump inlet is arranged on the target side of the partition wall and the pump outlet is arranged on the substrate side of the partition wall.

Preferably, the ratio between the diameter of the rotating body and the distance between the edge of the opening and the circumference of the rotating body is between 5 and 20. This ensures that a sufficient gap is present between the circumference of the rotating body and the edge of the opening to have a sufficient gas flow along the circumference, while the gap is still small enough to ensure that the gas flow will drag undesired particles along.

In a preferred embodiment of the device according to the invention a recess is provided in the edge of the opening to provide an auxiliary passage opening along the circumference of the rotating body from one side of the partition wall to the other side.

With the recess provided in the edge of the opening an auxiliary passage is provided along the circumference of the rotating body.

The auxiliary passage opening provided by the recess will steer the flow between the pump inlet and pump outlet along the circumference of the rotating body and reduces turbulence. This improves the discharge of particles from the reactor housing and thus away from the substrate.

In a preferred embodiment of the device according to the invention at least one radially extending rib is arranged on the one axial surface facing the target holder of the rotating body trailing from the at least one filter passage opening.

Preferably, the at least one radially extending rib is curving adjacent from the rotation axis towards the circumference of the rotating body and in opposite direction of the rotation direction.

The at least one radially extending rib will urge the floating, undesired particles towards the circumference of the rotating body, such that the undesired particles can be dragged along in the gas flow into the pump outlet.

In yet another embodiment of the device according to the invention, the pump outlet is arranged adjacent to the recess in the partition wall and relative to the partition wall on the side of the target holder.

By positioning the pump outlet adjacent to the recess, the undesired particles exiting the recess can be caught by the pump outlet.

These and other features of the invention will be elucidated in conjunction with the accompanying drawings.
Figure 1 shows a schematic cross-sectional view of an embodiment of a device according to the invention.
Figure 2 shows a bottom view of the velocity filter of the embodiment of figure 1.

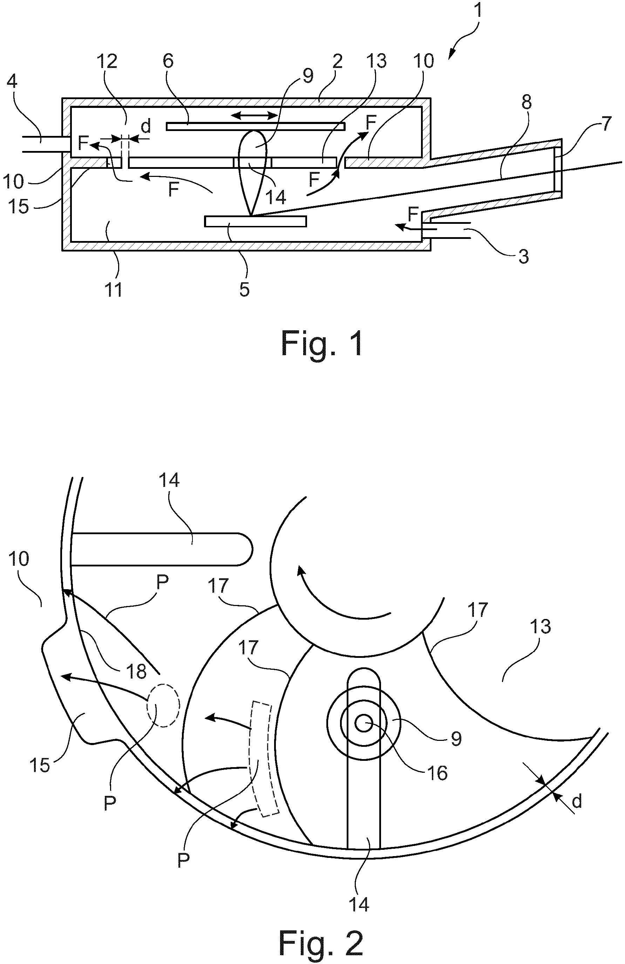

Figure 1 shows a schematic cross-sectional view of a device 1 for pulsed laser deposition. The device 1 has a reactor housing 2 with a pump inlet 3 and a pump outlet 4. A target holder with target 5 is arranged in the housing 2, as well as a substrate holder with substrate 6.

The reactor housing 2 has a window 7 through which a laser beam 8 can be directed on the target 5 to generate a plasma plume 9. This plasma plume 9 moves towards the substrate and is deposited on the surface thereof. By moving the substrate 6 the whole surface of the substrate 6 can be provided with a layer of target material.

The reactor housing 2 is divided by a partition wall 10 into a target chamber 11 and a substrate chamber 12. The partition wall 10 has an opening in which a velocity filter, having a rotating body 13 is positioned. The rotating body 13 is provided with a filter passage opening 14 through which the plasma plume 9 passes towards the substrate 6. The circumference of the rotating body 13 is spaced apart from the edge of the opening in the partition wall 10, such that a gap of a uniform width d along the circumference of the rotating body 13 is provided. This width is according to the invention between 10mm and 30mm.

A gas flow F, to obtain an desired gas atmosphere in the reactor housing 2, will flow from the pump inlet 3 through the gap d around the circumference of the rotating body 13 towards the pump outlet 4 and take any undesired particles along.

An auxiliary recess 15 is provided in the edge of the opening in the partition wall 10, such that the gas flow F is steered and the discharge of particles from the reactor housing and thus away from the substrate is further improved.

Figure 2 shows a bottom view of the velocity filter with the rotating body 13 arranged in the partition wall 10 with a gap having a width d. When the filter passage opening 14 is aligned with the target spot 16, which is irradiated by the laser beam 8, a plasma plume 9 will be ejected through the filter passage opening 14 towards the substrate 6.

Undesired particles P will be urged away by the curving radially extending ribs 17 as a result of the rotation of the rotating body 13. As a result the undesired particles P will be moved to the circumference 18 of the rotating body 13, such that the particles P can pass through the gap d. Also particles will enter the recess 15 and are taken along with the gas flow F. This ensures that the undesired particles P do not remain over the target spot 16 and be taken along with the next plasma plume 9, but are dragged along with the gas flow F, such that the particles P can be drained into the pump outlet 4.

It is noted that the curving radially extending ribs could also be provided on the other side of the rotating body or on both sides.

Comparative tests were performed with an identical system and parameters, in which only the size of the rotating body of the velocity filter was changed in order to change the width of the gap between the rotating body and the edge of the opening in the partition wall. All tests were performed using a substrate being a 200mm wafer on which target material was deposited.

For reference a rotating body with a diameter of 725mm was used, which leaves a gap of 5mm wide. Deposition of the full 200mm wafer is possible, but undesired particles which passed the filter passage opening in the velocity filter cannot be drained sufficiently quick with the gas flow F, such that these undesired particles are deposited onto the substrate.

A first test according to the invention was performed in the same system, in which the rotating body had a diameter of 655mm leaving a gap of 30mm wide.

Undesired particles passing through the filter passage opening were sufficiently drained away with the gas flow away from the substrate. This was clear from the low number of undesired particles present on the wafer. However, along the circumference of the wafer a larger number of particles were found than at the center of the wafer.

A second test according to the invention was performed with the same system, in which the rotating body had a diameter of 685mm leaving a gap of 20mm wide.

Undesired particles were filtered adequately and no substantial difference in number of undesired particles on the substrate between the circumference and the center were found.

From the comparative tests it is clear that a gap width of only 5mm results in too many undesired particles on the substrate. Increasing the gap width improves the quality of the substrate by reducing the number of undesired particles on the substrate. Only if the gap width is increased too much, the number of particles on the circumference of the substrate starts to rise again, which is undesired.

## Claims

1. Device for pulsed laser deposition, a substrate with a substrate surface and a target with a target surface, which device comprises:
- a reactor housing having a pump inlet and a pump outlet for providing a desired gas atmosphere in the reactor housing;
- a substrate holder arranged in the reactor housing for holding the substrate;
- a target holder arranged in the reactor housing for holding the target with the target surface facing the substrate surface of the substrate;
- a velocity filter arranged in the reactor housing and between the substrate holder and the target holder, which velocity filter comprises a rotating, generally disc-shaped body with a rotation axis and with at least one filter passage opening extending from one axial surface facing the target holder to the other axial surface of the rotating body facing the substrate holder; and
- a pulsed laser directed through a window arranged in the reactor housing onto the target at a target spot for generating a plasma plume of target material, wherein the surface of the target at the target spot faces the substrate surface,
wherein the path of the at least one filter passage opening coincides with the target spot when viewed in a direction perpendicular to the surface of the target at the target spot
**characterized by**
a partition wall arranged in the reactor housing, which partition wall extends between the substrate holder and the target holder, wherein the rotating, generally disc-shaped body of the velocity filter is arranged in an opening in the partition wall, wherein the circumference of the rotating body is enclosed by the edge of the opening in the partition wall and wherein the distance between the edge of the opening and the circumference of the rotating body in radial direction is between 10mm and 30mm.

2. Device according to claim 1, wherein the ratio between the diameter of the rotating body and the distance between the edge of the opening and the circumference of the rotating body is between 20 and 75.

3. Device according to claim 1 or 2,
wherein a recess is provided in the edge of the opening to provide an auxiliary passage opening along the circumference of the rotating body from one side of the partition wall to the other side.

4. Device according to any of the preceding claims, wherein at least one radially extending rib is arranged on the one axial surface facing the target holder of the rotating body trailing from the at least one filter passage opening.

5. Device according to claim 4, wherein the at least one radially extending rib is curving adjacent from the rotation axis towards the circumference of the rotating body and in opposite direction of the rotation direction.

6. Device according to any of the preceding claims, wherein the pump outlet is arranged adjacent to the recess in the partition wall and relative to the partition wall on the side of the target holder.
